# EUROPEAN PATENT APPLICATION

(11) **EP 2 660 859 A1**
(43) Date of publication of application: **06.11.2013**
(21) Application number: 11852567.4
(22) Date of filing: 27.12.2011
(51) Int. Cl.: H01L 21/677, B25J 15/06, B65G 49/07

(54) **CONTACTLESS CONVEYANCE APPARATUS**

(30) Priority: 27.12.2010 CN 201010607157
(71) Applicant: Li, Xin, Guangxi 545005 (CN); Kagawa, Toshiharu, Kanagawa 213-0013 (JP)
(72) Inventor: Li, Xin, Guangxi 545005 (CN); Kagawa, Toshiharu, Kanagawa 213-0013 (JP)
(74) Representative: Stebbing, Timothy Charles
(86) International application number: PCT/JP2011/080336
(87) International publication number: WO 2012/091066

(57) **Abstract**

[Problem] To control a lift force acting on an object being conveyed by non-contact conveyance equipment in a non-contact manner.

[Solution] A non-contact conveyance equipment that conveys an object in a non-contact manner, comprises a cup-shaped member including a concave portion, an air inlet, and an opening rim that faces the object, a fan provided inside the concave portion of the cup-shaped member, that rotates to suck air into the concave portion through the air inlet, the air forming a swirl flow in the concave portion, and an adjusting member provided at the cup-shaped member, that adjusts an amount of air sucked through the air inlet.

## Description

### Technical Field

The present invention relates to non-contact conveyance equipment.

### Background Art

In recent years, equipment for conveying an object such as a semiconductor wafer or a glass substrate in a non-contact manner has been developed. For example, Patent Document 1 proposes equipment for conveying an object in a non-contact manner, by applying Bernoulli's theory. In the equipment, a swirl flow is generated in a cylindrical chamber that opens on the underside of the equipment, and a negative pressure generated in the center of the swirl flow exerts suction on an object. On the other hand, a given distance is maintained between the equipment and the object by a fluid flowing out of the cylindrical chamber. Consequently, the object is conveyed in a non-contact manner.

### Prior Art Document

### Patent Document

Patent Document 1: JP 2005-51260 A

### Summary of the Invention

### Problems to be solved by the Invention

It is an object of the present invention to control a lift force acting on an object being conveyed by non-contact conveyance equipment in a non-contact manner.

### Means for Solving the Problems

The present invention provides non-contact conveyance equipment that conveys an object in a non-contact manner, comprising: a cup-shaped member including a concave portion, an air inlet, and an opening rim that faces the object; a fan provided inside the concave portion of the cup-shaped member, that rotates to suck air into the concave portion through the air inlet, the air forming a swirl flow inside the concave portion; and an adjusting member provided at the cup-shaped member, that adjusts an amount of air sucked through the air inlet.

### Effects of the Invention

According to the present invention, it is possible to control a lift force acting on an object being conveyed by non-contact conveyance equipment in a non-contact manner, as compared with a case in which an adjusting member for adjusting an amount of air sucked though an air inlet of non-contact conveyance equipment is not provided.

### Brief Description of the Drawings

Fig. 1 is a partial cross-sectional view of non-contact conveyance equipment 1 according to an embodiment of the present invention.
Fig. 2 is a sectional view and a plain view of non-contact conveyance equipment 1.
Fig. 3 is a diagram showing examples of another structure of fan 12 provided in non-contact conveyance equipment 1.
Fig. 4 is a chart showing distribution of pressure generated by non-contact conveyance equipment 1.
Fig. 5 is a diagram showing relation between a distance between non-contact conveyance equipment 1 and object 2, and a lift force.
Fig. 6 is a partial cross-sectional view of non-contact conveyance equipment 3.
Fig. 7 is a bottom view of non-contact conveyance equipment 3.
Fig. 8 is a sectional view of a cup according to a modification.
Fig. 9 is a partial cross-sectional view of non-contact conveyance equipment 1e according to a modification.
Fig. 10 is a partial cross-sectional view of non-contact conveyance equipment If according to a modification.
Fig. 11 is a partial cross-sectional view of non-contact conveyance equipment 1g according to a modification.

### Description of Reference Numerals

1, 1a, 1b, 1c, 1d, 1e ··· Non-contact conveyance equipment, 2 ··· Object, 3 ··· Non-contact conveyance equipment, 11, 11a, 11b ··· Cup, 12 ··· Fan, 13, 21 ··· Motor, 14 ··· Shutter, 15, 15a, 15b ··· Concave portion, 16 ··· Air inlet, 17 ··· Brace, 18, 22 ··· Rotating shaft, 19, 23 ··· Rotating shaft hole, 20 ··· Needle valve, 24 ··· Sensor, 25 ··· Controller, 111 ··· Bottom, 112 ··· Peripheral wall, 113 ··· Opening rim, 114 ··· Support table, 121 ··· Cylindrical member, 122 ··· Blade

### Modes for Implementing the Invention

### (1) Embodiment

A preferred embodiment of the present invention will be described below with reference to the drawings. Identical or equivalent components, members, or operations shown in the drawings are referenced by like reference numeral, and duplicate description thereof is omitted. The preferred embodiment is provided for purposes of illustration only and does not limit the present invention. Not all of the features or a combination of the features described in the embodiment necessarily are essential for the present invention.

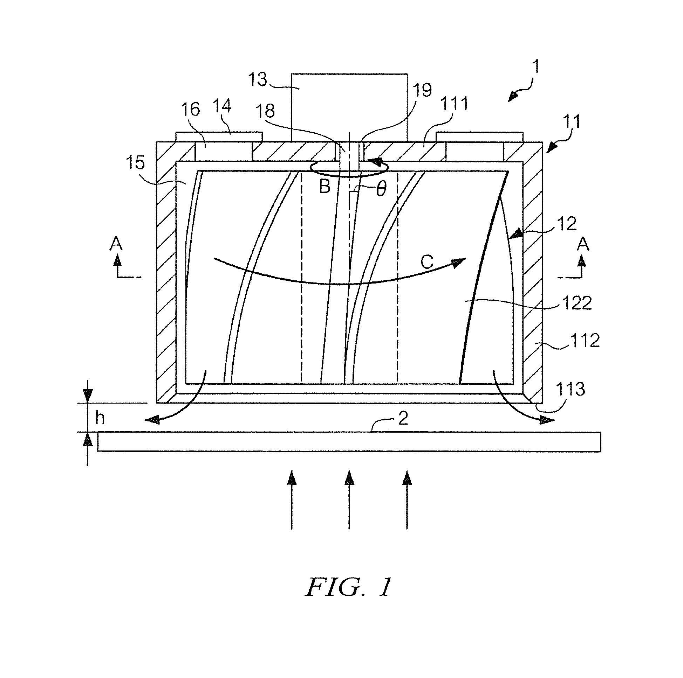

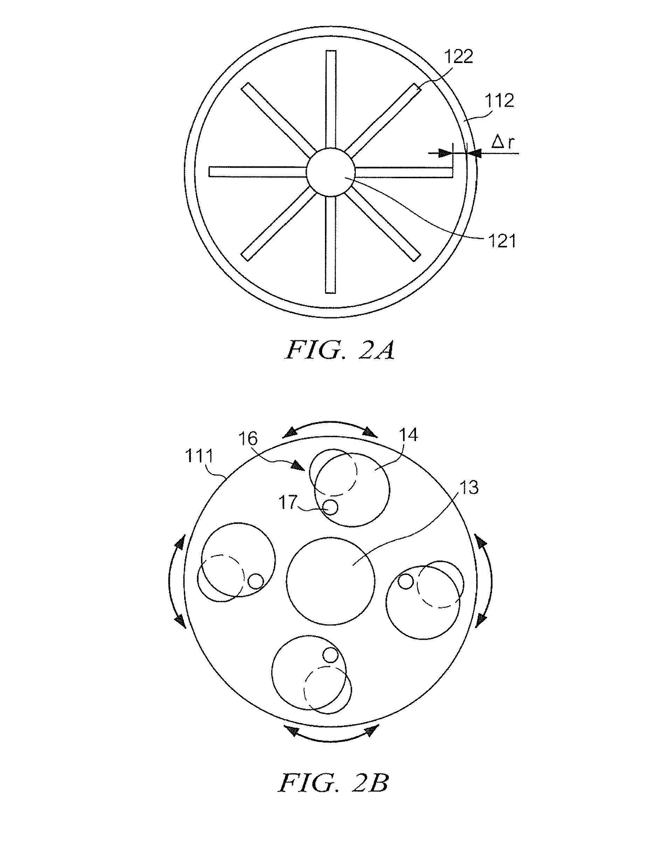

Fig. 1 is a partial cross-sectional view showing a configuration of non-contact conveyance equipment 1 according to the present embodiment. Non-contact conveyance equipment 1 comprises a cup-shaped member (hereinafter "cup") 11, fan 12, motor 13, and shutters 14. Non-contact conveyance equipment 1 is equipment for conveying object 2 such as a semiconductor wafer or a glass substrate in a non-contact manner. Fig. 2(a) is a cross-sectional view of non-contact conveyance equipment I shown in Fig. 1 along the line A-A. Fig. 2(b) is a plain view of non-contact conveyance equipment I shown in Fig. 1.

Cup 11 comprises disk-shaped bottom 111 and peripheral wall 112, which vertically extends from the rim of bottom 111. Cup 11 has concave portion 15 surrounded by bottom 111 and peripheral wall 112. The cross section of concave portion 15, which is parallel to bottom 111, has a circular shape so that resistance to swirl flow (described later) is decreased. However, a shape of the cross section is not limited to being circular, and may be elliptical or polygonal. The configuration of cup 11 is not limited to the circular cylindrical shape shown in Figs. 1 and 2, and may be any other shape such as a rectangular cylindrical shape, as long as concave portion 15 can be provided therein.

In non-contact conveyance equipment 1 shown in Fig. 1, cup 11 comprises air inlets 16, which are provided at bottom 111. In the example shown in Fig. 2(b), cup 11 comprises four air inlets 16, spaced evenly apart from each other around a circle. However, the number of air inlets 16 provided at cup 11 is not limited to four, and may be any number. Preferably, a number is between two to eight. Air inlets 16 may be provided at peripheral wall 112 of cup 11.

At bottom 111 of cup 11, shutters 14 are provided as shown in Fig. 2(b). Shutter 14 is a circular plate-shaped member, which is provided for each air inlet 16. Shutter 14 is fixed to bottom 111 with brace 17 so that shutter 14 is able to rotate around brace 17. A user of non-contact conveyance equipment 1 may change an area of air inlet 16 covered by shutter 14, by changing a position of shutters 14. It is to be noted that although in the example shown in Fig. 2(b), shutters 14 are arranged at a side of bottom 111 at which motor 13 is provided, shutters 14 may be arranged at a side at which motor 13 is not provided (namely, a side facing concave portion 15). In a case where air inlets 16 are provided at peripheral wall 112, shutters 14 may be provided at peripheral wall 112 as well. Although in the example shown in Fig. 2(b), areas of air inlets 16 covered by shutter 14 are equal, the areas may be different for each air inlet 16.

As shown in Fig. 2(a), fan 12 comprises cylindrical member 121 and plural blades 122, which extend from the periphery of cylindrical member 121 in a direction perpendicular to the central axis of cylindrical member 121. Each blade 122 consists of a rectangular plate, the upper side (a side near bottom 111 of cup 11) curved in a rotational direction. Angle θ (see Fig. 1) of the curvature of blade 122 ranges from 0.5 degrees to 2 degrees. Use of Curved blade 122 facilitates suction of air through air inlet 16. It is to be noted that blade 122 may be bent in a radial direction. The shape of blade 122 is not limited to being rectangular, and may be any other shape.

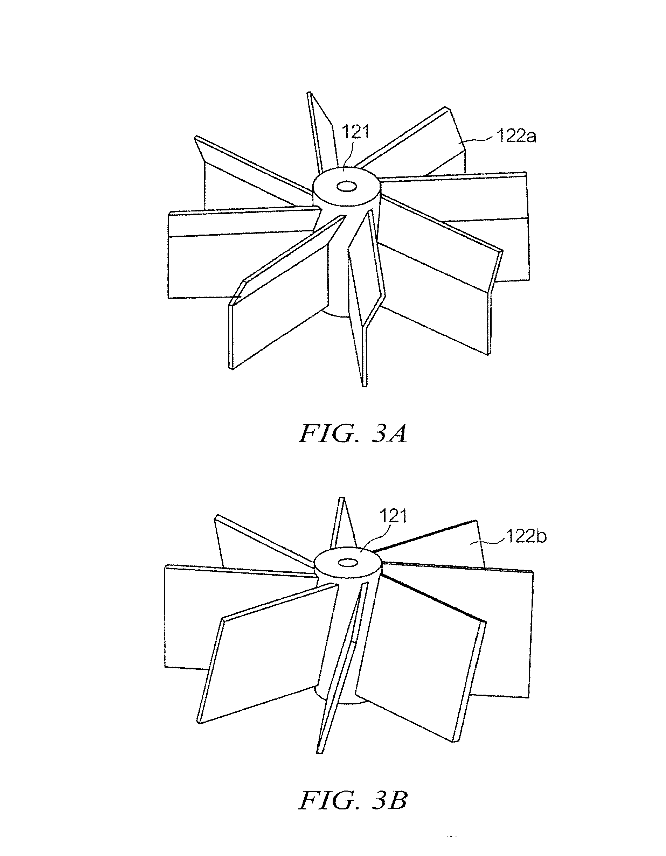

Figs. 3(a) and 3(b) are diagrams showing examples of another structure of a fan. In contrast to blades 122 shown in Fig. 1, which curve gradually, blade 122a shown in Fig. 3(a) is bent at a set height. Blades 122b shown in Fig. 3(b) are flat plates, not curved, and are attached to cylindrical member 121 so that they are inclined in a rotational direction relative to the central axis of cylindrical member 121. It is to be noted that a fan is not limited to a propeller fan, and may be a sirocco fan. A sirocco fan is a cylindrical fan, and more specifically is a fan having a cylindrical body whose peripheral wall consists of plural blades extending in an axial direction.

It is preferable that clearance Δr is provided between blade 122 and the inner wall of cup 11 as shown in Fig. 2(a) so that rotation of fan 12 is not prevented by air resistance. It is also preferable that a number of blades 122 ranges from six to twenty to generate a swirl flow effectively, with a minimum of four blades being sufficient.

Motor 13 is provided outside cup 11. Rotating shaft 18 of motor 13 is coupled to cylindrical member 121 of fan 12 via rotating shaft hole 22. Fan 12 rotates in direction B as motor 13 is driven. As fan 12 rotates, air is sucked into concave portion 15 through air inlets 16, and forms a swirl flow as indicated by arrow C. Opening rim 113 of cup 11 may be chamfered to decrease resistance to air flowing out of concave portion 15 toward object 2.

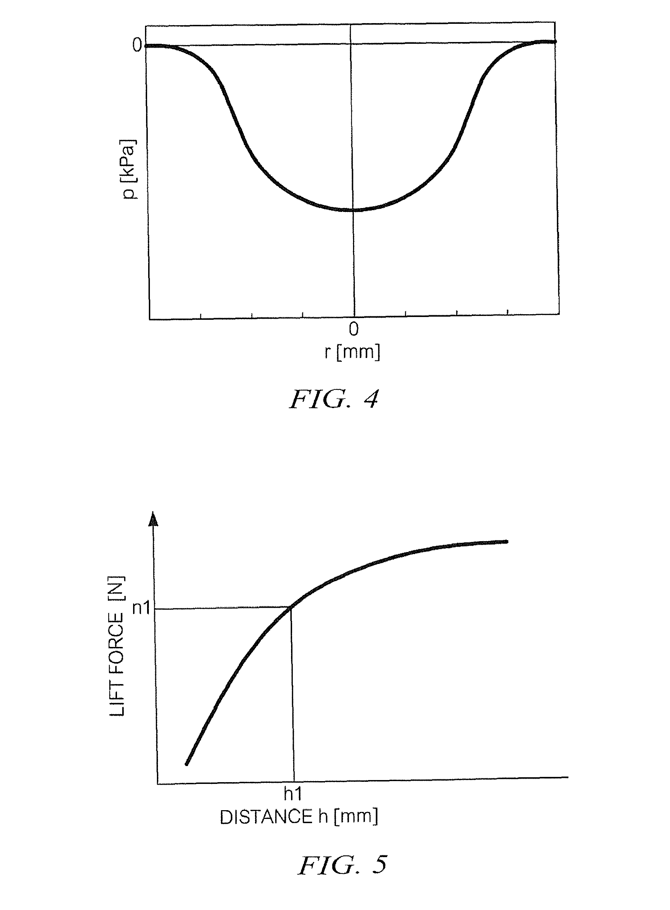

The foregoing is a description of a configuration of non-contact conveyance equipment 1. Now, operation of non-contact conveyance equipment 1 will be described. Object 2 is positioned opposite to opening rim 113 of cup 11. Accordingly, if motor 13 is driven at a rotating speed of, for example, 1,000 to 3,000 rpm, fan 12 rotates and air is sucked into concave portion 15 through air inlets 16, whereby a swirl flow is formed in concave portion 15. As the swirl flow is formed, air inside concave portion 15 is pulled outwards by a centrifugal force and a density of the air is reduced. As a result, a pressure inside concave portion 15 is reduced to below an atmospheric pressure (namely, to a negative pressure). Fig. 4 is a chart showing distribution of pressure generated by non-contact conveyance equipment 1 shown in Fig. 1. The horizontal axis shows position r of object 2 in a radial direction, and the vertical axis shows a pressure.

If object 2 is positioned opposite to opening rim 113 of cup 11, the upper surface of object 2 is subject to the negative pressure. The distribution of pressure is as shown in Fig. 4, and the central part of the upper surface of object 2 is subject to the lowest pressure. Object 2 is floated by a lift force generated by a difference in pressure acting on the upper and lower surfaces of object 2.

Fig. 5 is a diagram showing relation between distance h between opening rim 113 of cup 11 and object 2, and a lift force. As shown in the drawing, as a lift force increases, distance h increases until it reaches a certain value. In the drawing, reference numeral nl indicates an example of a weight of object 2. As shown in the drawing, object 2 having such a weight floats steadily at distance h1 from opening rim 113 of cup 11.

A lift force acting on object 2 may be adjusted by changing positions of shutters 14. For example, in a case where a part of each air inlet 16 is covered by shutter 14 as shown in Fig. 2(b), an amount of air flowing into concave portion 15 reduces as compared with a case in which air inlets 16 are not covered at all by shutters 14. As a result, a negative pressure generated inside concave portion 15 increases, so that a lift force acting on object 2 increases. In general, a lift force acting on object 2 increases, as an area of each air inlet 16 covered by shutter 14 increases, whereas the lift force decreases, as the area decreases.

It is to be noted that since a lift force acting on object 2 is correlated with distance h as shown in Fig. 5, distance h may be adjusted by changing positions of shutters 14. In general, distance h becomes shorter, as an area of each air inlet 16 covered by shutter 14 increases, whereas distance h becomes longer, as the area decreases.
The foregoing is a description of an operation of non-contact conveyance equipment 1.

### (2) Modifications

In the foregoing, the present invention has been described based on the embodiment, using specific terms. The embodiment merely illustrates the principles of the present invention and application. Various modifications and layout changes may be made to the invention described in the embodiment, without departing from the scope of the present invention defined in the claims. Examples of such modifications will be described below. The following modifications may be combined with each other.

### (2-1) Modification 1

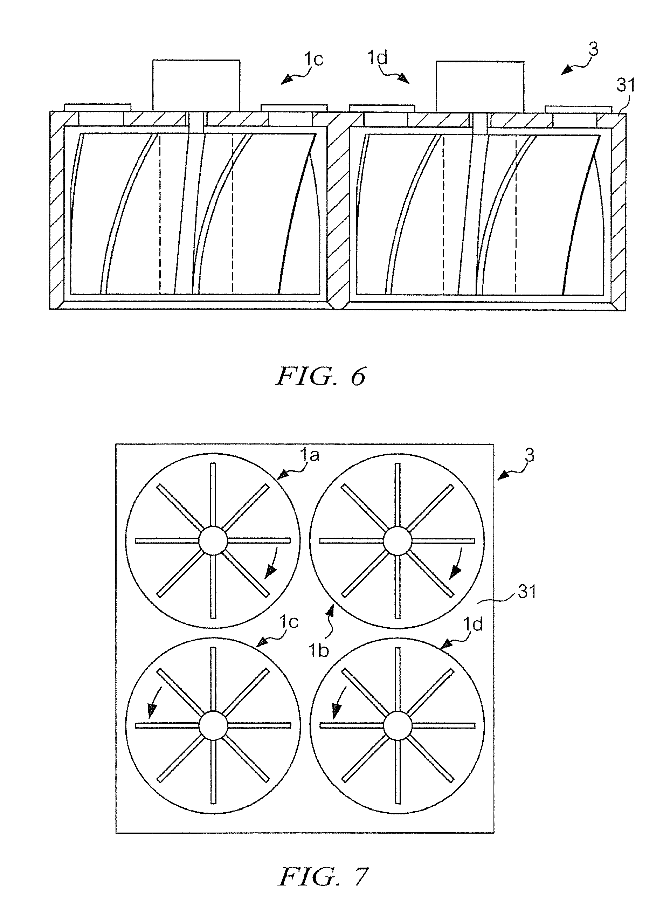

In a case where non-contact conveyance equipment 1 is used singly, object 2 may be rotated by swirl flow. To prevent such a problem, plural pieces of non-contact conveyance equipment may be used. Fig. 6 is a partial cross-sectional view showing a configuration of non-contact conveyance equipment 3, which comprises plural pieces of non-contact conveyance equipment. Fig. 7 is a bottom view of non-contact conveyance equipment 3. Non-contact conveyance equipment 3 shown in the drawings comprises four pieces of non-contact conveyance equipment 1a to 1d. Peripheral walls 112 of cups 11 of non-contact conveyance equipment 1a to 1d are coupled to form base 31.

The rotational direction of a swirl flow generated by each of non-contact conveyance equipment 1a to 1d is decided so that rotary torques acting on object 2 by non-contact conveyance equipment 1a to I d are cancelled. In the example shown in Fig. 7, among four pieces of non-contact conveyance equipment 1a to 1d, non-contact conveyance equipment 1a and 1b generate a swirl flow by rotating in a first direction, and non-contact conveyance equipment 1c and 1d generates a swirl flow by rotating in a second direction opposite to the first direction. Alternatively, among four pieces of non-contact conveyance equipment 1a to 1d, non-contact conveyance equipment 1a and 1c may generate a swirl flow by rotating in a first direction, and non-contact conveyance equipment 1b and 1d may generate a swirl flow by rotating in a second direction opposite to the first direction. A number of pieces of non-contact conveyance equipment that constitutes non-contact conveyance equipment 3 is not limited to four, and may be any other even number such as two, six, or eight.

### (2-2) Modification 2

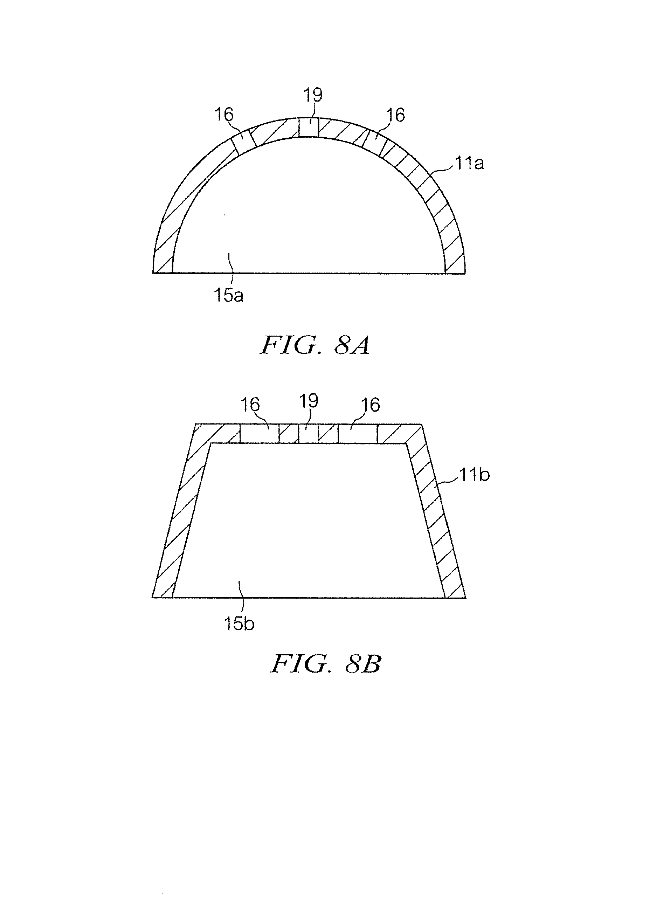

The shape of concave portion 15 of non-contact conveyance equipment 1 is not limited to being cylindrical as shown in Figs. 1 and 2, and may be substantially hemispheric or a shape of a cylindrical table. Fig. 8(a) is a cross-sectional view of cup 11a including substantially hemispherical concave portion 15a. Fig. 8(b) is a cross-sectional view of cup 11b including concave portion 15b, which has a cylindrical shape. In each case, blades 122 of fan 12 are designed to have a shape so that they fit inside the concave portion.

### (2-3) Modification 3

In above non-contact conveyance equipment 1, the shape of air inlets 16 is not limited to being circular as shown in Fig. 2(b), and may be elliptical or polygonal. Similarly, the shape of shutters 14 may be elliptical or polygonal. The relation between an angle of rotation of shutter 14 around brace 17 and an area of air inlet 16 covered by shutter 14, for example, in a case where when the angle of rotation of shutter 14 is 0 degree, the area is zero, may be linear, exponential, or logarithmic.

### (2-4) Modification 4

In above non-contact conveyance equipment 1, shutters 14 are fixed so that they are able to rotate around brace 17. However, shutters 14 may be screwed down. In this case, each time a position of shutter 14 is changed, the nut is unscrewed.

### (2-5) Modification 5

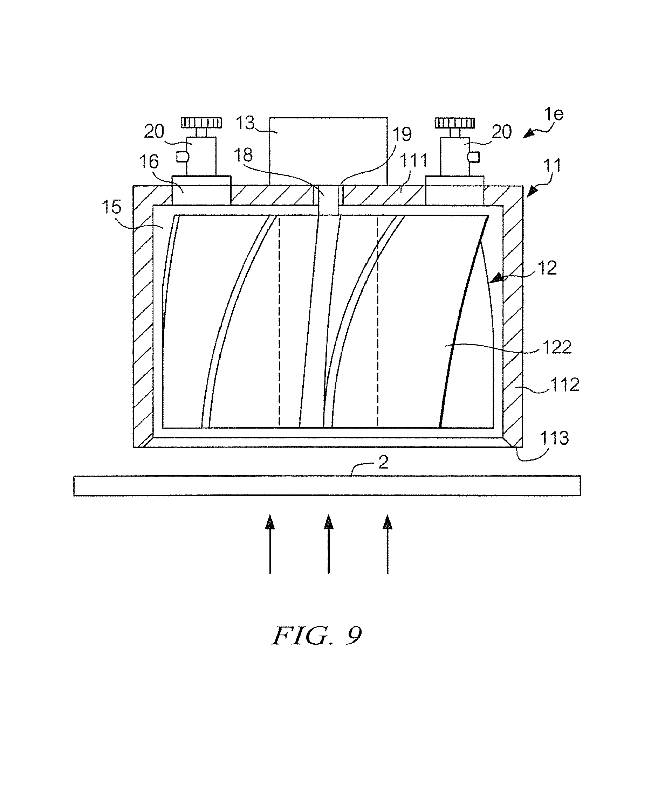

In the above non-contact conveyance equipment 1, shutters 14 may be a circular assembly consisting of plural shutter blades as in a behind-the-lens shutter of a camera, instead of a circular plate-shaped member.
Alternatively, in above non-contact conveyance equipment 1, valves such as needle valves 20 may be provided, instead of shutters 14. Fig. 9 is a partial cross-sectional view of non-contact conveyance equipment 1e, in which needle valves 20 are provided, instead of shutters 14. In this case, by rotating the handle of needle valve 20, an amount of air flowing into concave portion 15 of cup 11 is adjusted.

### (2-6) Modification 6

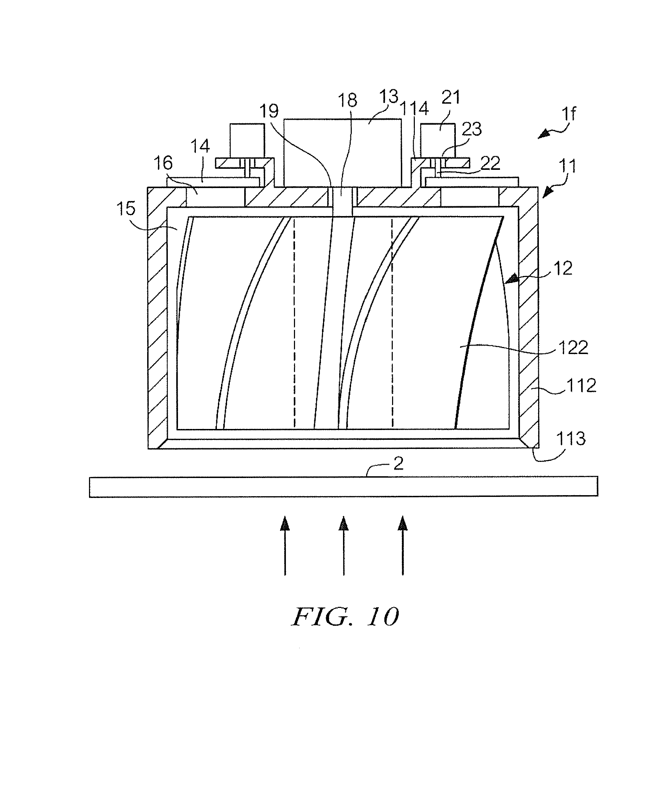

In above non-contact conveyance equipment 1, positions of shutters 14 are changed manually. However, positions of shutters 14 may be changed using a motor. Fig. 10 is a partial cross-sectional view of non-contact conveyance equipment 1f, in which motors 21 are provided for rotating shutters 14. In the example shown in the drawing, support tables 114 are provided on bottom 111 of cup 11, and motors 21 are provided on support tables 114. Rotating shaft 22 extending from each motor 21 is coupled to shutter 14 via rotating shaft hole 23. As motor 21 is driven, shutter 14 rotates around rotating shaft 22. Motors 21 are, for example, stepping motors.
In the example shown in Fig. 10, motor 21 is provided for each shutter 14. However, non-contact conveyance equipment may be provided with single motor 21, which rotates all of shutters 14 via gears.

### (2-7) Modification 7

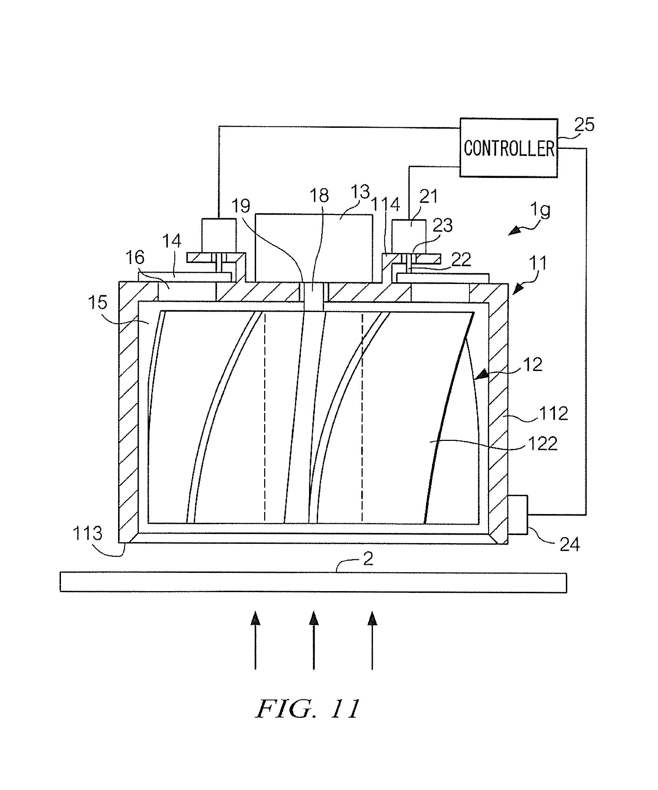

In the non-contact conveyance equipment according to modification 6, a sensor may be provided for measuring a distance between the equipment and object 2, and positions of shutters 14 may be changed based on a result of measurement by the sensor. Fig. 11 is a partial cross-sectional view of non-contact conveyance equipment 1g according to the present modification. In the example shown in the drawing, sensor 24 is provided as a means for measuring a distance between non-contact conveyance equipment 1g and object 2. Sensor 24 is, for example, an ultrasonic sensor.

Sensor 24 is connected to controller 25, and outputs a signal indicating a measured distance to controller 25. Controller 25 compares a distance indicated by the output signal and a predetermined distance, and controls motors 21 based on the difference. Specifically, controller 25, if a distance indicated by the signal is greater than a predetermined distance, controls motors 21 so that areas of air inlets 16 covered by shutters 14 are larger. As a result, an amount of air flowing into concave portion 15 decreases, so that a negative pressure generated inside concave portion 15 increases. Consequently, a lift force acting on object 2 increases.

On the other hand, if a distance indicated by the signal is shorter than a predetermined distance, controller 25 controls motors 21 so that areas of air inlets 16 covered by shutters 14 are smaller. As a result, an amount of air flowing into concave portion 15 increases, so that a negative pressure generated inside concave portion 15 decreases. Consequently, a lift force acting on object 2 decreases. The number of driving pulses to be output to motors 21 is proportional to the amount of the difference. Controller 25 is, for example, a microcomputer.

## Claims

1. Non-contact conveyance equipment that conveys an object in a non-contact manner, comprising:
a cup-shaped member including a concave portion, an air inlet, and an opening rim that faces the object;
a fan provided inside the concave portion of the cup-shaped member, that rotates to suck air into the concave portion through the air inlet, the air forming a swirl flow in the concave portion; and
an adjusting member provided at the cup-shaped member, that adjusts an amount of air sucked through the air inlet.
